# FASCICULE DE BREVET EUROPEEN

(11) **EP 2 700 919 B1**
(45) Date de publication et mention de la délivrance du brevet: **14.01.2015**
(21) Numéro de dépôt: 13179133.7
(22) Date de dépôt: 02.08.2013
(51) Int. Cl.: G01H 13/00, H03L 7/07, H03L 7/081

(54) **Circuit de mesure de fréquence de résonance de nanorésonateurs**
Schaltkreis zum Messen der Resonanzfrequenz von Nanoresonatoren
Circuit for measuring the resonance frequency of nanoresonators

(30) Priorité: 22.08.2012 FR 1257931
(43) Date de publication de la demande: 26.02.2014
(73) Titulaire: COMMISSARIAT A L'ENERGIE ATOMIQUE ET AUX ENERGIES ALTERNATIVES, 75015 Paris (FR)
(72) Inventeur: Villard, Parick, 38000 GRENOBLE (FR)
(74) Mandataire: Guérin, Michel

(56) Documents cités:
- WO-A2-02/090246
- US-A- 6 041 642
- US-A1- 2005 052 813

## Description

L'invention concerne les circuits à résonateurs électro-mécaniques micro-usinés et en particulier les oscillateurs à nanorésonateurs ou oscillateurs NEMS (de l'anglais "nanoelectromechanical systems", c'est-à-dire systèmes nano-électromécaniques). Ces systèmes intègrent sur un substrat des éléments mécaniques, micro-usinés à l'échelle du nanomètre par des technologies de fabrication collective de la microélectronique.

Ces circuits peuvent être utilisés notamment pour la mesure de masses très faibles, typiquement comprises entre 10⁻²⁴ et 10⁻²¹ grammes. Les applications visées sont par exemple l'analyse de gaz ou la spectrométrie de masse.

Dans de tels systèmes utilisant des résonateurs, le signal à mesurer est la fréquence de résonance du nano-résonateur, celle-ci dépendant en effet directement de la masse de matière déposée sur le résonateur, une masse plus importante engendrant une fréquence de résonance plus basse.

Un tel système est divulgué par la publication WO 02/090246 A2.

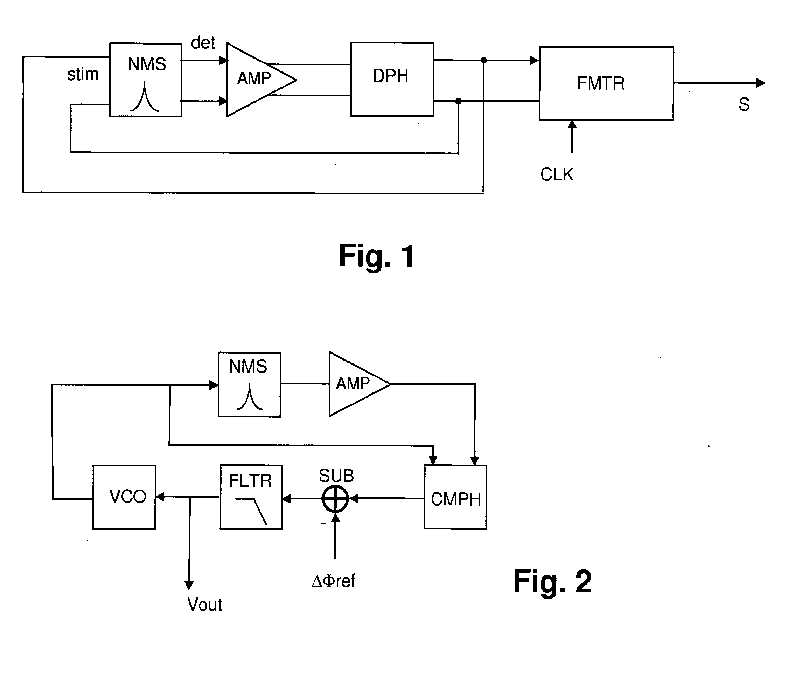

Pour mesurer la fréquence de résonance, on a déjà proposé d'utiliser un circuit auto-oscillant comprenant une boucle d'oscillation fermée incorporant le résonateur. La figure 1 représente schématiquement un tel circuit auto-oscillant. La boucle auto-oscillante comprend le résonateur NMS en série avec une chaîne d'amplification et de déphasage, et une contre-réaction entre la sortie de la chaîne et une entrée d'excitation du résonateur. La chaîne d'amplification apporte un gain par un amplificateur AMP et un déphasage par un déphaseur DPH ; elle permet d'assurer des conditions d'oscillation naturelle (gain de boucle ouverte supérieur ou égal en module à 1 pour un déphasage de boucle multiple de 2π). La fréquence d'oscillation est la fréquence de résonance mécanique naturelle du résonateur NMS. Elle est mesurée à la sortie de la chaîne d'amplification par un fréquencemètre FMTR. Ce dernier peut fonctionner par exemple sur le principe d'un comptage d'impulsions d'une horloge de référence CLK ayant une fréquence très supérieure à la fréquence d'oscillation. La sortie analogique ou numérique S du fréquencemètre fournit une mesure de la fréquence de résonance propre du résonateur. Cette solution permet de réaliser des circuits peu encombrants, ce qui est important notamment dans le cas où on souhaite réaliser un réseau comportant un grand nombre de nano-résonateurs. Mais, comme il y a une grande dispersion technologique des résonateurs et des composants de la chaîne d'amplification, il est difficile de garantir a priori l'obtention des conditions de gain et de phase qui permettent une oscillation naturelle spontanée à la fréquence de résonance.

On a également proposé des circuits à boucle d'asservissement de phase (boucle PLL), tel que celui qui est représenté schématiquement sur la figure 2. Le circuit comprend encore un nano-résonateur NMS en série avec un amplificateur AMP, un oscillateur contrôlé en tension (VCO) ou un oscillateur contrôlé numériquement (DCO) pour exciter le résonateur (NMS), un comparateur de phase CMPH, et un soustracteur SUB pour soustraire à la sortie du comparateur de phase une valeur (modulo 2π) qui représente le déphasage naturel ΔΦref introduit par le résonateur et l'amplificateur à la fréquence de résonance. Un filtre passe-bas FLTR est interposé entre la sortie du comparateur de phase et une entrée de commande de l'oscillateur pour assurer la stabilité de la boucle d'asservissement.

La valeur ΔΦref est une valeur une valeur de déphasage mesurée par calibration en faisant fonctionner le résonateur et l'amplificateur en boucle ouverte à la fréquence de résonance et en observant le déphasage entre le signal d'excitation du résonateur et la sortie de l'amplificateur.

Le circuit s'asservit automatiquement sur la fréquence pour laquelle le déphasage entre les entrées du comparateur de phase est égal à ΔΦref ; cette fréquence est la fréquence de résonance naturelle du résonateur. En effet, en boucle fermée, la sortie du comparateur de phase représente le déphasage du résonateur et de l'amplificateur. S'il n'est pas égal à ΔΦref, la tension de commande de l'oscillateur VCO s'ajuste jusqu'à ce qu'il devienne égal à ΔΦref, déphasage correspondant à la résonance. La mesure de la fréquence de résonance se fait ensuite par la mesure de la tension de commande Vout de l'oscillateur, cette tension représentant la fréquence d'oscillation de l'oscillateur. Cette solution à boucle PLL nécessite une calibration préalable pour connaître le déphasage ΔΦref à la résonance.

Les circuits utilisant une telle boucle de verrouillage de phase consomment plus de courant que les circuits fonctionnant en oscillation naturelle. De plus ils sont encombrants.

Un but de l'invention est de réaliser un circuit de mesure de fréquence de résonance qui bénéficie des avantages des circuits PLL pour garantir une mise en oscillation forcée à la fréquence de résonance, malgré les dispersions technologiques, mais qui consomme moins d'énergie et qui puisse être réalisé de manière moins encombrante dans le cas où on utilise en parallèle un grand nombre de résonateurs NEMS en réseau.

Selon l'invention on propose un circuit électronique de mesure de la fréquence d'oscillation d'un résonateur, comportant une première boucle d'asservissement qui est une boucle à verrouillage de phase comprenant le résonateur, un oscillateur à fréquence contrôlée et un premier comparateur de phase, cette boucle asservissant la fréquence d'un oscillateur contrôlé à la fréquence de résonance du résonateur, le circuit de mesure étant **caractérisé en ce qu'il** comporte en outre :
- une deuxième boucle d'asservissement comprenant un déphaseur commandable, un deuxième comparateur de phase recevant la sortie de l'oscillateur contrôlé et la sortie du déphaseur commandable, le deuxième comparateur de phase fournissant un signal de commande du déphaseur agissant dans un sens tendant à réduire à zéro le déphasage entre ses entrées, des moyens étant prévus pour mémoriser la commande de déphasage obtenue,
- une troisième boucle qui est une boucle d'auto-oscillation, comprenant le résonateur et le déphaseur commandable et reliant la sortie du déphaseur commandable à l'entrée du résonateur,
- et des moyens pour activer la première boucle et la deuxième boucles et désactiver la troisième boucle, pendant une phase de calibration, et pour désactiver la première et la deuxième boucles et activer la troisième boucle, pendant une phase d'exploitation, la commande du déphaseur commandable pendant la phase d'exploitation étant la commande mémorisée à la fin de la phase de calibration.

La première boucle d'asservissement comprend de préférence le résonateur en série avec un amplificateur, le premier comparateur de phase recevant sur une entrée la sortie de l'amplificateur et sur une autre entrée la sortie de l'oscillateur à fréquence contrôlée et fournissant une mesure du déphasage entre ses entrées, un soustracteur pour soustraire à cette mesure du déphasage une valeur de déphasage de référence, la sortie du soustracteur commandant l'oscillateur contrôlé.

Globalement, le circuit selon l'invention fonctionne de la manière suivante :
- dans une phase de calibration, on désactive la troisième boucle, c'est-à-dire qu'on coupe la liaison entre la sortie du déphaseur commandé et l'entrée d'excitation du résonateur ; ce dernier n'est commandé que par la sortie de l'oscillateur contrôlé, lequel est asservi par la première boucle d'asservissement. Le résonateur entre en résonance grâce à cette première boucle qui est active. La deuxième boucle d'asservissement, également active, détermine l'écart de phase réel qui existe alors (en résonance) entre l'entrée d'excitation du résonateur et la sortie de l'amplificateur. Cet écart de phase est mémorisé ; c'est un écart tel que la somme de cet écart et du déphasage du résonateur et de l'amplificateur soit multiple de 2π ;
- dans une phase d'exploitation, on neutralise la première et la deuxième boucle d'asservissement mais on garde en mémoire l'écart de phase mesuré en phase de calibration pour l'utiliser pendant la phase d'exploitation ; on applique une commande de phase mémorisée au déphaseur commandable ; on remet en service la troisième boucle en reliant la sortie de ce déphaseur à l'entrée du résonateur ; la troisième boucle entre en oscillation à la fréquence de résonance car le déphasage de boucle est multiple de 2π.

Un filtre passe-bas peut être prévu dans la première boucle entre une sortie du soustracteur et une entrée de commande de l'oscillateur contrôlé, et un autre filtre passe-bas peut être prévu dans la deuxième boucle d'asservissement entre une sortie du deuxième comparateur de phase et les moyens de mémorisation de la commande du déphaseur.

Une quatrième boucle d'asservissement, mise en service pendant la phase de calibration, peut être prévue pour établir un signal de commande de gain de l'amplificateur tel que le gain de la chaîne comprenant le résonateur, l'amplificateur, et le déphaseur, soit supérieur à 1 pendant la phase de calibration ; un moyen est alors prévu pour mettre en mémoire ce signal de commande de gain et pour appliquer le signal de commande mémorisé à l'amplificateur pendant la phase d'exploitation

L'invention est particulièrement applicable à la mesure de fréquence de résonateurs multiples organisés en réseau de lignes et de colonnes. La troisième boucle est alors individuelle pour chaque résonateur et est adressable par un conducteur de ligne commun aux résonateurs d'une même ligne. La première et la deuxième boucles d'asservissement sont au contraire communes aux résonateurs d'une même colonne et sont reliées, par des conducteurs de colonne respectifs, communs aux résonateurs d'une même colonne, aux composants de celle des troisièmes boucles qui est adressée par un conducteur de ligne.

D'autres caractéristiques et avantages de l'invention apparaîtront à la lecture de la description détaillée qui suit et qui est faite en référence aux dessins annexés dans lesquels :
- la figure 1, déjà décrite, représente un circuit auto-oscillant à nano-résonateur ;
- la figure 2, déjà décrite, représente un circuit oscillant à nano-résonateur, comportant une boucle à verrouillage de phase ;
- la figure 3 représente un circuit oscillant selon l'invention ;
- la figure 4 représente le circuit oscillant configuré pour une phase de calibration ;
- la figure 5 représente le circuit oscillant configuré pour une phase de mesure de fréquence de résonance ;
- la figure 6 représente une variante de réalisation avec contrôle de gain ;
- la figure 7 représente une utilisation de l'invention dans le cadre d'un réseau matriciel de nano-résonateurs utilisant une première et une deuxième boucles d'asservissement commune à tous les pixels et une troisième boucle d'auto-oscillation spécifique à chaque nano-résonateur ;
- la figure 8 représente un déphaseur à commande numérique utilisable dans l'invention.

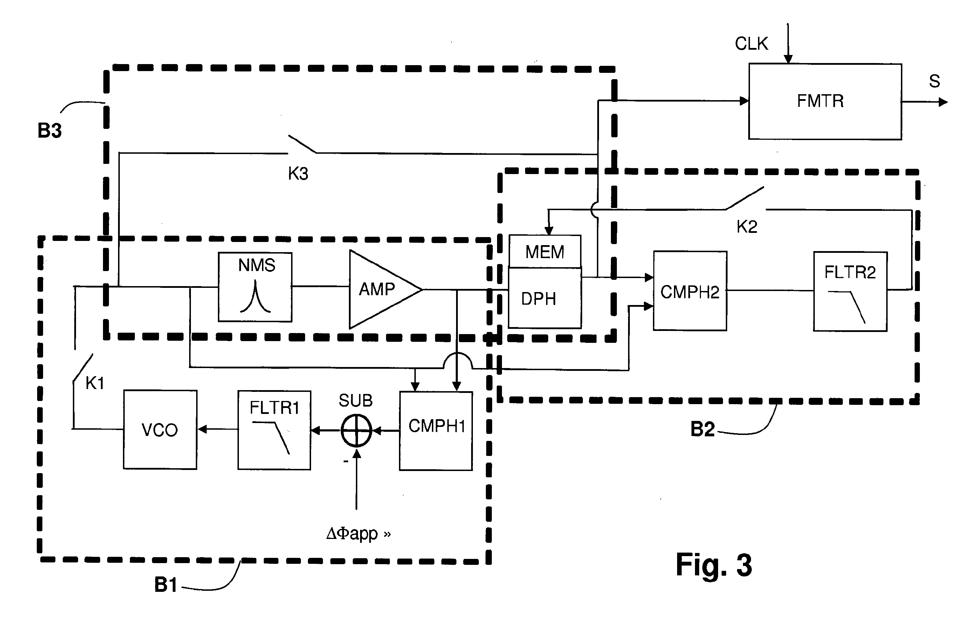

La figure 3 représente un schéma bloc du circuit selon l'invention permettant la mesure de fréquence de résonance d'un nano-résonateur.

Il se compose de trois boucles d'asservissement B1, B2, B3 représentées chacune dans un rectangle tireté respectif. Chacune de ces boucles peut être mise en service ou hors service indépendamment. La mise en service ou hors service de chaque boucle est schématisée ici par un interrupteur respectif K1, K2, K3 qui connecte (mise en service de la boucle) ou déconnecte (mise hors service de la boucle) une liaison de contre-réaction propre à chaque boucle.

La première boucle B1 est une boucle à verrouillage de phase semblable à celle de la figure 2. Elle comprend un nano-résonateur NMS, un amplificateur AMP, un oscillateur à fréquence contrôlé VCO qui peut être commandé par une tension analogique ou par une commande numérique, un comparateur de phase CMPH1 et un soustracteur SUB. Pour simplifier les explications on considère que la commande de l'oscillateur VCO est analogique. L'oscillateur VCO sert de source d'excitation pour le résonateur, c'est-à-dire que sa sortie est reliée à une entrée d'excitation du résonateur. L'amplificateur AMP amplifie le signal de sortie du résonateur. Le comparateur de phase CMPH1 fournit une mesure analogique ou numérique de la différence de phase entre les signaux présents sur ses entrées, à savoir sur une première entrée le signal d'excitation du résonateur, et sur une deuxième entrée le signal de sortie de l'amplificateur. La sortie analogique ou numérique du comparateur de phase est appliquée à un soustracteur SUB qui soustrait à la mesure faite par le comparateur une valeur ΔΦapp. Cette valeur est une valeur estimée du déphasage introduit par le résonateur et l'amplificateur à la fréquence de résonance. Cette valeur peut être approximative. Elle permet de s'assurer qu'on est assez près des conditions d'oscillation naturelle du résonateur ; elle peut être obtenue par une caractérisation préalable en boucle ouverte ou par la connaissance des caractéristiques générales du résonateur, mais elle n'a pas besoin d'être exacte et en particulier elle n'a pas besoin de tenir compte de la dispersion entre les caractéristiques réelles de différents résonateurs de mêmes caractéristiques nominales.

Un filtre passe-bas FLTR1 peut être prévu pour assurer la stabilité de la boucle, entre la sortie du soustracteur et une entrée de commande de l'oscillateur VCO.

L'interrupteur K1 qui permet de mettre en service ou hors service la première boucle B1 est placé entre la sortie de l'oscillateur VCO et l'entrée d'excitation du résonateur ; il pourrait être placé à d'autres endroits, en faisant attention toutefois que la mise hors service de la boucle B1 ne doit pas empêcher la mise en service de la troisième boucle B3 qui utilise aussi le résonateur NMS et l'amplificateur AMP.

Lorsque la boucle B1 est en service, l'oscillateur ajuste automatiquement sa fréquence à la fréquence de résonance du résonateur NMS : si la fréquence de l'oscillateur est trop basse, le comparateur de phase fournit une valeur qui augmente et qui tend à remonter la fréquence d'oscillation.

La deuxième boucle d'asservissement B2 comprend un déphaseur commandable DPH, un deuxième comparateur de phase CMPH2, un filtre passe-bas de stabilisation FLTR2, et une mémoire MEM pouvant stocker une consigne de commande de valeur de déphasage.

Le déphaseur DPH reçoit la sortie de l'amplificateur AMP et applique au signal de sortie de l'amplificateur un déphasage qui est défini par le contenu de la mémoire MEM. Lorsque la boucle B2 est en service, le contenu de la mémoire peut varier et s'asservit automatiquement dans un sens qui annule le déphasage entre les entrées du comparateur de phase CMPH2. Lorsqu'elle est hors service, le contenu de la mémoire MEM est figé à la valeur prise pendant que la boucle était en service. La sortie du déphaseur est appliquée à une première entrée du deuxième comparateur de phase CMPH2. Le signal d'excitation du résonateur NMS est appliqué sur une autre entrée du deuxième comparateur de phase. La sortie du deuxième comparateur de phase est appliquée au filtre FLTR2 et de là à la mémoire MEM si la boucle B2 est en service. L'interrupteur K2 qui définit la mise en service ou hors service de la boucle B2 est représenté par un interrupteur inséré dans la liaison entre la sortie du filtre FLTR2 et l'entrée de la mémoire MEM. Lorsqu'il est fermé, la boucle B2 est en service. Lorsqu'il est ouvert, elle est hors service.

Lorsque la boucle B2 est en service, le deuxième comparateur de phase CMPH2 fournit une mesure de la différence de phase entre la sortie du déphaseur DPH et l'entrée d'excitation du résonateur. Il asservit la commande du déphaseur dans un sens tendant à ramener à zéro (modulo 2π) cette différence de phase, c'est-à-dire que la mémoire MEM reçoit une valeur de commande (analogique ou de préférence numérique) telle que le déphasage introduit par le déphaseur compense exactement le déphasage du résonateur et de l'amplificateur. Lorsque la boucle d'asservissement B2 n'est plus en service (c'est-à-dire qu'elle n'assure plus d'asservissement), la mémoire MEM impose au déphaseur DPH ce déphasage de compensation.

La troisième boucle B3 comprend l'ensemble en série du résonateur NMS, de l'amplificateur AMP, et du déphaseur commandable DPH, et une liaison de contre-réaction directe entre la sortie du déphaseur DPH et l'entrée du résonateur NMS. Cette liaison peut être interrompue par l'interrupteur K3 si la boucle B3 doit être mise hors service. Lorsque la boucle B3 est en service (les deux autres boucles étant mises hors service), l'ensemble du résonateur, de l'amplificateur, du déphaseur, et de la liaison de contre-réaction passe en mode d'auto-oscillation à la fréquence de résonance du résonateur. Le déphasage introduit par le déphaseur DPH sous la commande de la consigne stockée dans la mémoire compense exactement le déphasage que présentent à la fréquence de résonance le résonateur et l'amplificateur. Les conditions d'oscillation naturelles (déphasage multiple de 2π et gain supérieur ou égal à 1 obtenu par l'amplificateur) sont réunies.

Dans une phase de calibration, la troisième boucle est interrompue par l'interrupteur K3 alors que les deux autres boucles sont en service. La boucle à verrouillage de phase B1 établit une oscillation à la fréquence de résonance du résonateur et la boucle B2 asservit la valeur du déphasage du déphaseur DPH et mémorise la commande nécessaire pour obtenir un déphasage multiple de 2π entre l'entrée du résonateur et la sortie du déphaseur. Dans la phase d'exploitation, les deux boucles B1 et B2 sont mises hors service par les interrupteurs K1 et K2 mais la commande de déphasage est conservée en mémoire. La troisième boucle B3 est mise en service et entretient l'auto-oscillation en utilisant la commande mise en mémoire.

La fréquence d'oscillation peut alors être mesurée par le fréquencemètre FTMR. Ce dernier peut fonctionner par comptage d'impulsions d'une horloge CLK à une fréquence très supérieure à la fréquence de résonance.

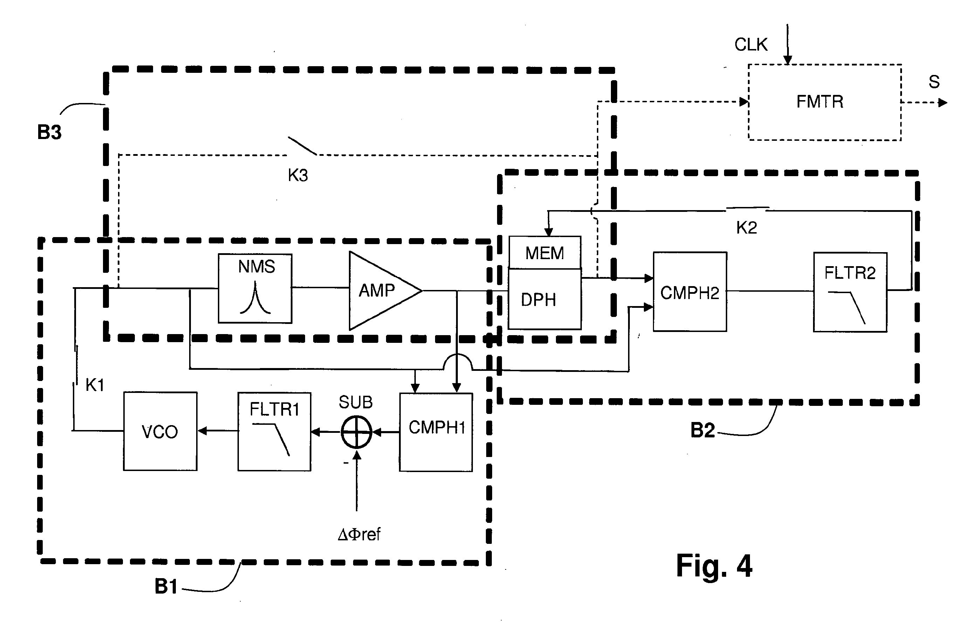

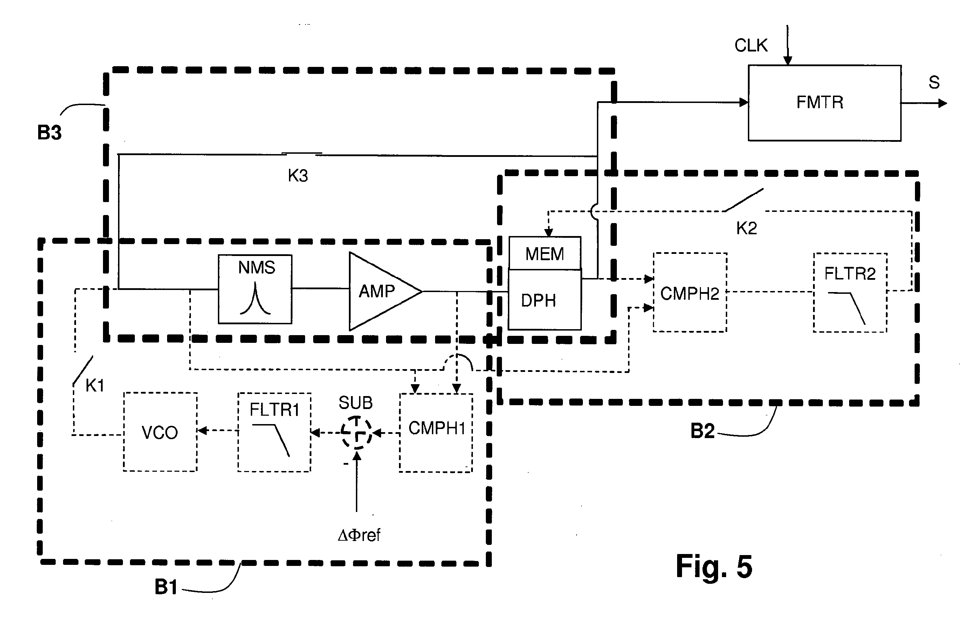

La figure 4 représente la configuration du circuit selon l'invention dans la phase de calibration. La figure 5 représente la configuration du circuit dans la phase d'exploitation. Dans ces deux figures, les éléments de circuit non utilisés sont représentés en pointillés.

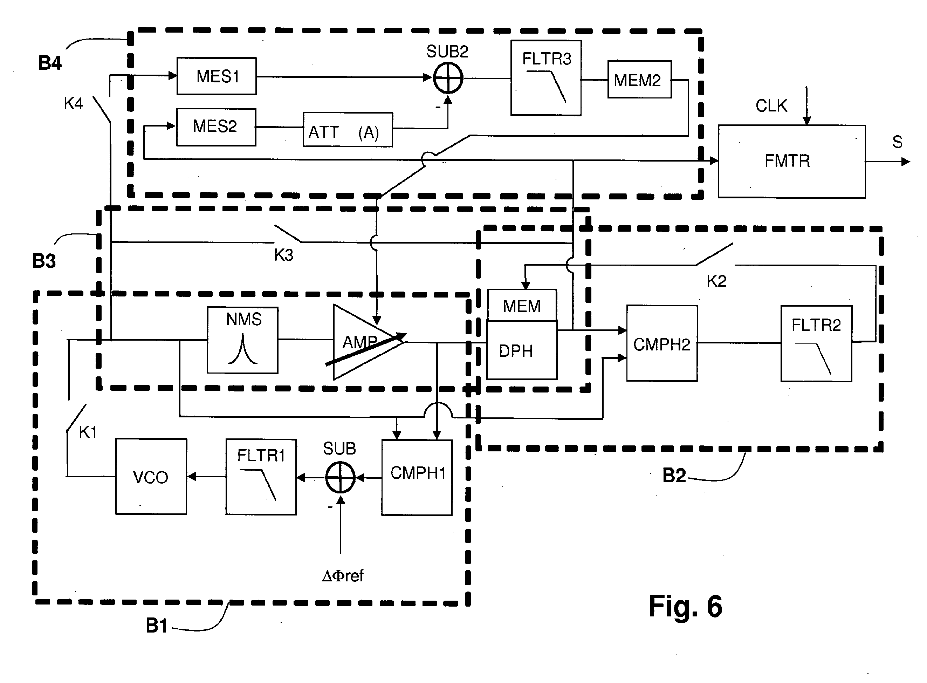

La figure 6 représente une variante de réalisation dans laquelle on a ajouté une boucle d'asservissement supplémentaire B4 dont le rôle est d'établir un gain approprié pour l'amplificateur AMP dans le but d'assurer les conditions de gain de boucle nécessaires à l'auto-oscillation de la boucle B3. Ces conditions sont moins critiques que les conditions de phase mais il est avantageux de les prendre en compte.

L'amplificateur AMP est dans cette configuration un amplificateur à gain variable commandé. La boucle d'asservissement établit un gain approprié pendant la phase de calibration de gain, qui a lieu en même temps que la phase de calibration de déphasage. La commande pour obtenir ce gain est mémorisée dans une mémoire MEM2. En phase d'exploitation, la boucle d'asservissement B4 est mise hors service mais la valeur de commande de gain mémorisée est conservée et utilisée pour commander l'amplificateur fonctionnant dans la troisième boucle B3 et lui imposer le gain défini dans la phase de calibration.

Pour établir le gain approprié, on peut mesurer (circuits de mesure MES1 et MES2) les amplitudes de signal, par exemple les amplitudes de crête à l'aide de détecteurs de crête, à l'entrée du résonateur NMS et en sortie du déphaseur DPH, et on peut effectuer une régulation par soustraction (soustracteur SUB2) entre les niveaux de signal à l'entrée du résonateur et à la sortie du déphaseur DPH pour ramener à une valeur de gain prédéfinie, égale ou supérieure à 1, le rapport entre ces deux niveaux de signal. Pendant la phase de calibration, la boucle B4 est mise en service et asservit le gain sur une valeur de consigne qui peut être égale à 1 ou de préférence supérieure à 1. Un gain différent de la valeur de consigne se traduit par une modification de la commande de gain de l'amplificateur dans un sens tendant à ramener le gain vers la valeur de consigne. Si les circuits de mesure MES1 et MES2 fournissent un même niveau de mesure pour un même niveau de signal appliqué à leur entrée, la consigne de gain est définie à partir de l'atténuation A (A<1) d'un atténuateur ATT mis en série avec le circuit de mesure MES2 sur l'entrée négative du soustracteur SUB2 : l'asservissement de la boucle B4 tend à imposer une consigne de gain à l'amplificateur AMP telle que le gain de l'ensemble en série du résonateur, de l'amplificateur, et du déphaseur tende vers une valeur égale à 1/A. La présence de l'atténuation A assure une marge de gain de la boucle B3 lorsqu'elle est mise en service, pour garantir que son gain reste supérieur ou égal à 1 malgré les dispersions technologiques.

On remarquera que le circuit selon l'invention, bien qu'il emploie une boucle à verrouillage de phase, consommant plus d'énergie qu'un simple circuit auto-oscillant tel que celui de la figure 1, a une consommation relativement limitée car la boucle à verrouillage de phase ne fonctionne que pendant la phase de calibration.

L'invention est particulièrement intéressante dans le cas d'un réseau de résonateurs, par exemple un réseau matriciel de lignes et colonnes de résonateurs.

A chaque point P_{i,j} du réseau à l'intersection d'une ligne de rang i et d'une colonne de rang j, on prévoit un circuit oscillant individuel correspondant à la boucle B3, c'est-à-dire un circuit B3_{i,j} comprenant un résonateur NMS_{i,j}, un amplificateur AMP_{i,j}, un déphaseur DPH_{i,j}, et une mémoire élémentaire de commande de phase MEM_{i,j}. Ces éléments peuvent être de petites dimensions et de faible consommation électrique en l'absence de boucle à verrouillage de phase.

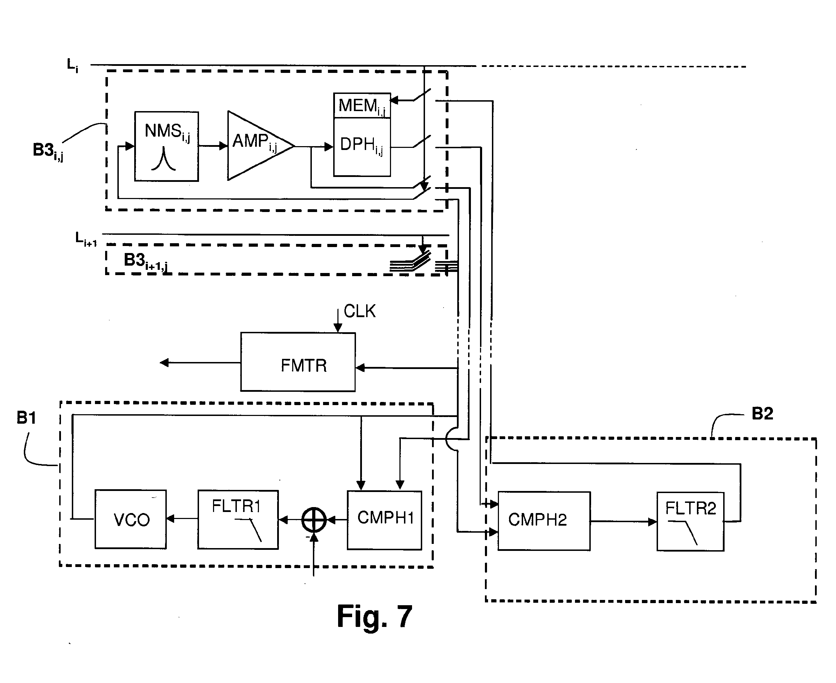

Mais les boucles B1 et B2 utilisées dans les phases de calibration peuvent être communes à tous les points d'une même colonne de résonateurs, voire même à toutes les colonnes. La figure 7 représente un schéma d'organisation d'une telle matrice de résonateurs. On a supposé pour simplifier qu'il n'y a pas de boucle de recherche de gain B4 mais on pourrait envisager une telle boucle.

On peut prévoir quatre conducteurs de colonne associés à chaque colonne respective. Les circuits individuels de chaque point sont adressables individuellement en ligne pour reporter les signaux adéquats sur chacun des conducteurs de colonne. Les circuits en pied de colonne (boucles B1, B2) utilisent les signaux présents sur les conducteurs de colonne (ou appliquent des signaux sur les conducteurs de colonne).

Un premier conducteur de colonne relie, lorsque la ligne de rang i est adressée, l'entrée du résonateur NMS_{i,j} à une entrée du comparateur de phase CMPH1 de la boucle B1 en pied de colonne, à une entrée du comparateur de phase CMPH2 de la boucle B2, à la sortie de l'oscillateur VCO de la boucle B1,et à une entrée d'un fréquencemètre FMTR.

Un deuxième conducteur de colonne relie, lorsque la ligne de rang i est adressée, la sortie de l'amplificateur AMP_{i,j} à la deuxième entrée du comparateur de phase CMPH1 de la boucle B1.

Un troisième conducteur de colonne relie, lorsque la ligne de rang i est adressée, la sortie du déphaseur DPH_{i,j} à la deuxième entrée du comparateur de phase CMPH2 de la boucle B2.

Un quatrième conducteur de colonne relie, lorsque la ligne de rang i est adressée, la mémoire de commande de phase MEM_{i,j} à la sortie de la boucle B2 (c'est-à-dire la sortie du filtre FLTR2).

On n'a pas représenté sur la figure 7 les interrupteurs de mise en service ou hors service des boucles B1, B2 (extérieurs à la matrice de points) et B3 (localisée à chaque point).

Les filtres FLTR1 et FLTR2 peuvent être des filtres numériques relativement encombrants (incluant des convertisseurs analogiques-numériques) car ils sont extérieurs à la matrice de résonateurs.

Le fonctionnement de la matrice peut consister en un adressage tournant des lignes successives, l'adressage d'une même ligne déterminée incluant successivement une phase de calibration, avec mémorisation à chaque point d'une commande de déphasage respective, et une phase d'exploitation utilisant la commande mémorisée et transmettant un signal à fréquence de résonance au fréquencemètre.

Mais on peut envisager aussi d'effectuer d'abord un adressage successif de toutes les lignes pendant une phase de calibration avec mise en mémoire des commandes de déphasage, suivi d'un adressage successif de toutes ces lignes pendant une phase d'exploitation utilisant la commande mémorisée.

On notera que dans le circuit selon l'invention, le déphaseur peut être à commande analogique ou à commande numérique, l'avantage d'une commande numérique étant qu'on peut mémoriser plus facilement (avec un très petit circuit de quelques points mémoire SRAM) la commande de déphasage déterminée pendant la phase de calibration.

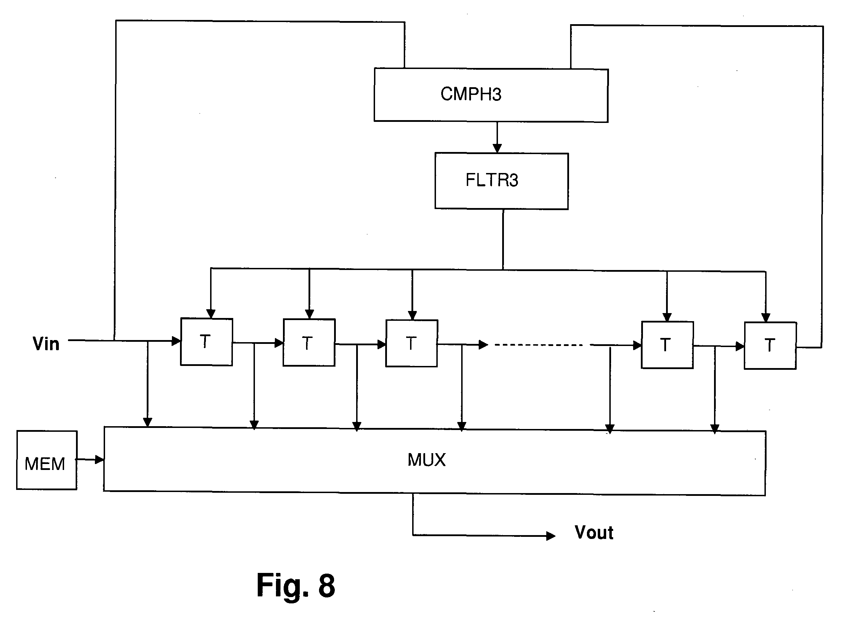

Un déphaseur à commande numérique peut être réalisé par exemple de la manière représentée à la figure 8, avec une boucle à verrouillage de retard comprenant une série de N éléments à retard T tous identiques et tous ajustables par une même tension de commande. Cette tension de commande est issue d'un comparateur de phase et d'un filtre. Le premier élément de retard reçoit un signal d'entrée Vin à déphaser. Le comparateur de phase reçoit l'entrée Vin du premier élément de retard et la sortie du dernier. Il établit par contre-réaction une tension de commande Vctl qui annule la phase entre ses deux entrées, ce qui établit un déphasage de 2π entre l'entrée et la sortie de la série d'éléments de retard. Le déphasage établi par chaque élément de retard est 2π/N. Un multiplexeur MUX commandé par le contenu d'une mémoire sélectionne le i^{ème} déphaseur pour établir un signal de sortie Vout de déphasage 2iπ/N par rapport au signal d'entrée.

## Revendications

1. Circuit électronique de mesure de la fréquence d'oscillation d'un résonateur (NMS), comportant une première boucle d'asservissement (B1) qui est une boucle à verrouillage de phase comprenant le résonateur, un oscillateur à fréquence contrôlée et un premier comparateur de phase (CMPH1), cette boucle asservissant la fréquence de l'oscillateur contrôlé (VCO) à la fréquence de résonance du résonateur, **caractérisé en ce qu'il** comporte en outre :
- une deuxième boucle d'asservissement (B2) comprenant un déphaseur commandable (DPH), un deuxième comparateur de phase (CMPH2) recevant la sortie de l'oscillateur contrôlé et la sortie du déphaseur commandable, et le deuxième comparateur de phase fournissant un signal de commande du déphaseur agissant dans un sens tendant à réduire à zéro le déphasage entre ses entrées, des moyens (MEM) étant prévus pour mémoriser la commande de déphasage obtenue,
- une troisième boucle d'auto-oscillation (B3) comprenant le résonateur et le déphaseur commandable et reliant la sortie du déphaseur commandable à l'entrée du résonateur,
- et des moyens pour activer la première boucle (B1) et la deuxième boucles (B2) et désactiver la troisième boucle (B3), pendant une phase de calibration, et pour désactiver la première et la deuxième boucles et activer la troisième boucle, pendant une phase d'exploitation, la commande du déphaseur commandable pendant la phase d'exploitation étant la commande mémorisée à la fin de la phase de calibration.

2. Circuit électronique de mesure selon la revendication 1, **caractérisé en ce que** la première boucle d'asservissement comprend le résonateur (NMS) en série avec un amplificateur (AMP), le premier comparateur de phase (CMPH1) recevant sur une entrée la sortie de l'amplificateur et sur une autre entrée la sortie de l'oscillateur contrôlé (VCO) et fournissant une mesure du déphasage entre ses entrées, un soustracteur (SUB) pour soustraire à cette mesure du déphasage une valeur de déphasage de référence (ΔΦref), la sortie du soustracteur commandant l'oscillateur contrôlé.

3. Circuit électronique de mesure selon l'une des revendications 1 et 2, **caractérisé en ce qu'**un filtre passe-bas est prévu dans la première boucle entre une sortie du soustracteur et une entrée de commande de l'oscillateur contrôlé.

4. Circuit électronique de mesure selon l'une des revendications 1 à 3, **caractérisé en ce qu'**un filtre passe-bas est prévu dans la deuxième boucle d'asservissement entre une sortie du deuxième comparateur de phase et les moyens de mémorisation de la commande du déphaseur.

5. Circuit électronique de mesure selon l'une des revendications 1 à 4, **caractérisé en ce qu'il** comporte une quatrième boucle d'asservissement (B4) mise en service pendant la phase de calibration, pour établir un signal de commande de gain de l'amplificateur tel que le gain de la chaîne comprenant le résonateur, l'amplificateur et le déphaseur soit supérieur à 1 pendant la phase de calibration, et un moyen pour mettre en mémoire ce signal de commande de gain et pour appliquer le signal de commande mémorisé à l'amplificateur pendant la phase d'exploitation

6. Circuit électronique de mesure selon l'une des revendications précédentes, **caractérisé en ce qu'il** comporte un réseau de lignes et colonnes de résonateurs, la troisième boucle d'auto-oscillation étant individuelle pour chaque résonateur et étant adressable par un conducteur de ligne commun aux résonateurs d'une même ligne, la première et la deuxième boucles d'asservissement étant communes aux résonateurs d'une même colonne et étant reliée, par des conducteurs de colonne communs aux résonateurs d'une même colonne, aux éléments de celle des troisièmes boucles qui est adressée par un conducteur de ligne.

## Patentansprüche

1. Elektronische Schaltung zum Messen der Oszillationsfrequenz eines Resonators (NMS), umfassend einen ersten Regelkreis (B1), der ein Phasenregelkreis ist, der den Resonator, einen Oszillator mit geregelter Frequenz und einen ersten Phasenkomparator (CMPH1) umfasst, wobei dieser Kreis die Frequenz des gesteuerten Oszillators (VCO) auf die Resonanzfrequenz des Resonators regelt, **dadurch gekennzeichnet, dass** sie ferner Folgendes umfasst:
- einen zweiten Regelkreis (B2), der einen steuerbaren Phasenschieber (DPH), einen zweiten Phasenkomparator (CMPH2), der den Ausgang des gesteuerten Oszillators und den Ausgang des steuerbaren Phasenschiebers empfängt, und den zweiten Phasenkomparator umfasst, der ein Steuersignal des Phasenschiebers liefert, das in einer Richtung wirkt, die dazu neigt, die Phasenverschiebung zwischen seinen Eingängen auf null zu reduzieren, wobei Mittel (MEM) zum Speichern des erhaltenen Phasenverschiebungsbefehls vorgesehen sind,
- einen dritten Autooszillationskreis (B3), der den Resonator und den steuerbaren Phasenschieber umfasst und den Ausgang des steuerbaren Phasenschiebers mit dem Eingang des Resonators verbindet,
- und Mittel zum Aktivieren des ersten Kreises (B1) und des zweiten Kreises (B2) und zum Deaktivieren des dritten Kreises (B3) während einer Kalibrationsphase und zum Deaktivieren des ersten und zweiten Kreises und zum Aktivieren des dritten Kreises während einer Betriebsphase, wobei der Befehl des steuerbaren Phasenschiebers während der Betriebsphase der am Ende der Kalibrationsphase gespeicherte Befehl ist.

2. Elektronische Messschaltung nach Anspruch 1, **dadurch gekennzeichnet, dass** der erste Regelkreis den Resonator (NMS) in Serie mit einem Verstärker (AMP) umfasst, wobei der erste Phasenkomparator (CMPH1) an einem Eingang den Ausgang des Verstärkers und an einem anderen Eingang den Ausgang des gesteuerten Oszillators (VCO) empfängt und ein Maß für die Phasenverschiebung zwischen seinen Eingängen liefert, ein Subtrahierglied (SUB) zum Subtrahieren eines Referenzphasenverschiebungswertes (ΔΦref) von diesem Phasenverschiebungsmaß, wobei der Ausgang des Subtrahierglieds den gesteuerten Oszillator steuert.

3. Elektronische Messschaltung nach einem der Ansprüche 1 und 2, **dadurch gekennzeichnet, dass** ein Tiefpassfilter im ersten Kreis zwischen einem Ausgang des Substrahierglieds und einem Steuereingang des gesteuerten Oszillators vorgesehen ist.

4. Elektronische Messschaltung nach einem der Ansprüche 1 bis 3, **dadurch gekennzeichnet, dass** ein Tiefpassfilter im zweiten Regelkreis zwischen einem Ausgang des zweiten Phasenkomparators und den Mitteln zum Speichern des Befehls des Phasenschiebers vorgesehen ist.

5. Elektronische Messschaltung nach einem der Ansprüche 1 bis 4, **dadurch gekennzeichnet, dass** sie einen vierten Regelkreis (B4), der während der Kalibrationsphase betrieben wird, zum Erzeugen eines Verstärkungssteuersignals des Verstärkers, so dass die Verstärkung der den Resonator, den Verstärker und den Phasenschieber enthaltenden Kette während der Kalibrationsphase größer als 1 ist, und ein Mittel zum Speichern dieses Verstärkungssteuersignals und zum Anlegen des gespeicherten Befehlssignals an den Verstärker während der Betriebsphase umfasst.

6. Elektronische Messschaltung nach einem der vorherigen Ansprüche, **dadurch gekennzeichnet, dass** sie eine Anordnung von Resonatorreihen und -spalten umfasst, wobei der dritte Autooszillationskreis für jeden Resonator individuell ist und von einem den Resonatoren einer selben Reihe gemeinsamen Reihenleiter adressiert werden kann, wobei der erste und der zweite Regelkreis den Resonatoren einer selben Spalte gemeinsam sind und von den Resonatoren einer selben Spalte gemeinsamen Spaltenleitern mit den Elementen von der der dritten Kreise verbunden sind, die von einem Reihenleiter adressiert wird.

## Claims

1. Electronic circuit for measuring the oscillation frequency of a resonator (NMS), comprising a first feedback loop (B1) which is a phase-locked loop comprising the resonator, a controlled oscillator and a first phase comparator (CMPH1), this loop locking the frequency of the controlled oscillator (VCO) at the resonant frequency of the resonator, **characterized in that** it also comprises:
- a second feedback loop (B2) comprising a controllable phase shifter (DPH), a second phase comparator (CMPH2) receiving the output of the controlled oscillator and the output of the controllable phase shifter, and the second phase comparator supplying a control signal for the phase shifter acting in a direction tending to reduce to zero the phase shift between its inputs, means (MEM) being provided for storing the phase-shift control signal obtained,
- a third self-oscillation loop (B3) comprising the resonator and the controllable phase shifter and linking the output of the controllable phase shifter to the input of the resonator,
- and means for activating the first loop (B1) and the second loop (B2) and deactivating the third loop (B3), during a calibration phase, and for deactivating the first and the second loops and activating the third loop, during an operation phase, the control of the controllable phase shifter during the operation phase being the control stored at the end of the calibration phase.

2. Electronic measurement circuit according to Claim 1, **characterized in that** the first feedback loop comprises the resonator (NMS) in series with an amplifier (AMP), the first phase comparator (CMPH1) receiving, on one input, the output of the amplifier and, on another input, the output of the controlled oscillator (VCO) and supplying a measurement of the phase shift between its inputs, a subtractor (SUB) for subtracting from this measurement of the phase shift a reference phase-shift value (ΔΦref), the output of the subtractor controlling the controlled oscillator.

3. Electronic measurement circuit according to one of Claims 1 and 2, **characterized in that** a low-pass filter is provided in the first loop between an output of the subtractor and a control input of the controlled oscillator.

4. Electronic measurement circuit according to one of Claims 1 to 3, **characterized in that** a low-pass filter is provided in the second feedback loop between an output of the second phase comparator and the control storage means of the phase shifter.

5. Electronic measurement circuit according to one of Claims 1 to 4, **characterized in that** it comprises a fourth feedback loop (B4) enabled during the calibration phase, for establishing a gain control signal for the amplifier such that the gain of the subsystem comprising the resonator, the amplifier and the phase shifter is greater than 1 during the calibration phase, and a means for storing this gain control signal and for applying the stored control signal to the amplifier during the operation phase.

6. Electronic measurement circuit according to one of the preceding claims, **characterized in that** it comprises a network of rows and columns of resonators, the third self-oscillation loop being individual for each resonator and being addressable by a row conductor common to the resonators of one and the same row, the first and the second feedback loops being common to the resonators of one and the same column and being linked, by column conductors common to the resonators of one and the same column, to the elements of that of the third loops which is addressed by a row conductor.
